(19) Europäisches Patentamt
European Patent Office
Office européen des brevets

(11) EP 0 480 311 B1

(12) # EUROPÄISCHE PATENTSCHRIFT

(45) Veröffentlichungstag und Bekanntmachung des Hinweises auf die Patenterteilung:
**08.07.1998 Patentblatt 1998/28**

(51) Int Cl.$^6$: **G03F 7/004**, G03F 7/039

(21) Anmeldenummer: **91116895.3**

(22) Anmeldetag: **04.10.1991**

(54) **Strahlungsempfindliches Gemisch enthaltend säurelabile Gruppierungen und Verfahren zur Herstellung von Reliefmustern und Reliefbildern**

Radiation-sensitive mixture containing an acid-cleavable group and process for obtaining relief patterns and images

Compositions photosensibles contenant des groups labiles en présence d'acide et procédé de fabrication d'images et de modèles en relief

(84) Benannte Vertragsstaaten:
**DE FR GB**

(30) Priorität: **10.10.1990 DE 4032162**

(43) Veröffentlichungstag der Anmeldung:
**15.04.1992 Patentblatt 1992/16**

(73) Patentinhaber: **BASF Aktiengesellschaft**
**67063 Ludwigshafen (DE)**

(72) Erfinder:
- **Schwalm, Reinhold, Dr.**
  **W-6706 Wachenheim (DE)**
- **Binder, Horst**
  **W-6840 Lampertheim (DE)**

(74) Vertreter: **Isenbruck, Günter, Dr. et al**
**Patent- und Rechtsanwälte**
**Bardehle-Pagenberg-Dost-Altenburg-Frohwitter-Geissler & Partner**
**Theodor-Heuss-Anlage 12**
**68165 Mannheim (DE)**

(56) Entgegenhaltungen:
**EP-A- 342 494**
**EP-A- 372 408**
**DE-A- 2 306 248**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 480 311 B1

Printed by Jouve, 75001 PARIS (FR)

## Beschreibung

Die Erfindung betrifft positiv arbeitende strahlungsempfindliche Gemische, die ein wäßrig-alkalisch lösliches Bindemittel, eine Verbindung, die mindestens eine durch Säure spaltbare Bindung enthält und unter Einwirkung von Strahlung eine starke Säure bildet, wobei die Löslichkeit der Verbindung in einem alkalischen Lösungsmittel durch die Einwirkung der Säure erhöht wird, sowie weitere Verbindungen enthalten. Diese Gemische sind sensitiv gegenüber UV-, Elektronen- und Röntgenstrahlen und eignen sich besonders als Resistmaterialien.

Positiv arbeitende strahlungsempfindliche Gemische sind bekannt. Positiv arbeitende Resistmaterialien, die o-Chinondiazide in wäßrig-alkalischen Bindemitteln, z.B. Novolake enthalten, werden als Photoresiste eingesetzt, so daß auch die Verfahren zur Herstellung von Reliefbildern bekannt sind. Die Empfindlichkeit dieser Systeme gegenüber Strahlung ist jedoch teilweise unbefriedigend.

Daher hat man strahlungsempfindliche Systeme entwickelt, welche in der Primärphotoreaktion eine Spezies erzeugen, die dann unabhängig von der Strahlung eine katalytische Sekundärreaktion auslösen und dadurch die Empfindlichkeiten drastische erhöhen. Solche Systeme, die photochemisch eine starke Säure erzeugen, die dann in einer Sekundärreaktion säurelabile Gruppen spalten, sind z.B. aus US-PS 3 923 514, US-PS 3 915 706, und DE-A 34 06 927 bekannt.

Weiterhin werden in der DE-A 37 21 741 strahlungsempfindliche Gemische vorgeschlagen, die ein in wäßrig-alkalischen Lösungen lösliches polymeres Bindemittel enthalten sowie eine organische Verbindung, deren Löslichkeit in einem wäßrig alkalischen Entwickler durch Einwirkung von Säure erhöht wird und die mindestens eine durch Säure spaltbare Gruppierung enthält, wobei die organische Verbindung unter Einwirkung von Strahlung eine starke Säure erzeugt.

Ein Nachteil dieser Systeme ist deren Empfindlichkeit gegenüber Kontaminationen, welche den photochemisch erzeugten Katalysator desaktivieren. Solche Desaktivierungsreaktionen spielen besonders beim Lagern zwischen dem Verfahrensschritt Belichtung und dem darauf folgendem Prozeß der Sekundärreaktion zur Abspaltung der säurelabilen Gruppen, meist durch Ausheizen unterstützt, eine entscheidende Rolle, indem die Entwicklung nicht mehr einwandfrei möglich ist und Lackreste oder Restschichten auf dem Wafer zurückbleiben.

In der EP 0372408-A3 wird ein strahlungsempfindliches Gemisch beschrieben, das aus einem in Wasser unlöslichen, in wäßrig-alkalischen Lösungen löslichen Bindemittel, einer bei Bestrahlung eine starke Säure bildende Verbindung und einem Monoketal einer β-Dicarbonylverbindung besteht, wobei in dieser Kombination Bindemittel auf Novolak-Basis bevorzugt sind.

Die EP 0342494-A2 betrifft ein strahlungsempfindliches Gemisch aus einem in Wasser unlöslichen, in wäßrig-alkalischen Lösungen löslichen polymeren Bindemittel (a), einer organischen Verbindung (b), deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält sowie zusätzlich einer nicht photoempfindlichen, mindestens eine durch Säure spaltbare Bindung enthaltenden organischen Verbindung (c), deren Löslichkeit in einem wäßrig-alkalischen Entwickler durch Einwirkung von Säure erhöht wird, oder einer nicht photoempfindlichen, mindestens eine durch Säure spaltbare Bindung enthaltenden organischen Verbindung (d), die sich durch Einwirkung von Säure so zersetzt, daß sie durch Behandlung bei Temperaturen von 60 bis 120°C vollständig entfernt werden kann, wobei als Verbindung (d) Derivate der Pyrokohlensäure oder der Orthokohlensäure genannt werden.

Aufgabe der vorliegenden Erfindung war es, strahlungsempfindliche Gemische aufzuzeigen, mit denen man Photoresiste auf Basis säuresäurekatalytischer Reaktionen, insbesondere lichtempfindlicher positiv arbeitender Beschichtungsmaterialien, bestehend aus in wäßrig-alkalischen Lösungen löslichem Bindemittel und einer organischen Verbindung, die mindestens eine durch Säure spaltbare Bindung und eine unter Einwirkung von Strahlung eine starke Säure bildende Gruppierung enthält, zu Reliefmustern verarbeiten kann, wobei ein praxisgerechter Verarbeitungsspielraum, insbesondere in bezug auf Lagerzeiten zwischen Belichtung und Ausheizschritten, ermöglicht wird und die Restschichtbildung auf dem Wafer vermieden wird.

Diese Aufgabe läßt sich durch die erfindungsgemäßen Gemische sehr vorteilhaft lösen.

Gegenstand der vorliegenden Erfindung ist ein strahlungsempfindliches Gemisch, enthaltend

(a) ein in Wasser unlösliches, in wäßrig-alkalischen Lösungen lösliches polymeres Bindemittel auf Basis von Homo- oder Copolymeren des p-Hydroxistyrols und/oder p-Hydroxi-α-methylstyrols und

(b) eine organischen Verbindung, deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält,
das dadurch gekennzeichnet ist, daß das strahlungsempfindliche Gemisch zusätzlich

(c) mindestens eine organische Verbindung enthält, die bei Temperaturen von bis zu 120°C, gegebenenfalls auch säurekatalysiert, mit Wasser oder stärkeren Nukleophilen reagiert, wobei diese organischen Verbindungen (c) ausgewählt sind aus der Gruppe der Vinyl- oder Enolether, der Orthocarbonsäureester der Formel

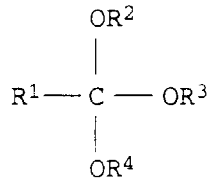

wobei $R^1$ = H, eine substituierte oder unsubstituierte Alkylgruppe mit 1 bis 12 Kohlenstoffatomen, eine substituierte oder unsubstituierte Phenylgruppe, oder eine substituierte oder unsubstituierte Cycloalkylgruppe mit 5 oder 6 Kohlenstoffatomen ist, $R^2$ bis $R^4$ gleich oder verschieden sind und für Alkyl oder Alkenyl mit 1 bis 12 Kohlenstoffatomen, Cycloalkyl, Cycloalkenyl mit jeweils 5 oder 6 C-Atomen oder substituiertes oder unsubstituiertes Aryl, stehen, der Carbonsäureanhydride aliphatischer Carbonsäuren, der Carbonsäureester von Di- oder Polycarbonsäuren mit 1 bis 4 Kohlenstoffatome enthaltenden Alkoholen, der Diazo- oder Diazoniumverbindungen und der Acetale und Ketale, wobei Monoketale von β-Dicarbonylverbindungen ausgenommen sind.

Bevorzugt sind dabei strahlungsempfindliche Gemische mit polymeren Bindemitteln (a) auf Basis von Homo- oder Copolymeren des p-Hydroxistyrols und/oder p-Hydroxi-α-methylstyrols, wobei als Comonomereneinheiten besonders in o-Stellung mono- oder disubstituierte Hydroxistyrole oder Hydroxistyrole, deren phenolische Gruppe mit säurelabilen Gruppierungen geschützt ist, in Frage kommen.

Bevorzugt als organische Verbindungen (b) sind Sulfoniumsalze der allgemeinen Formel (I)

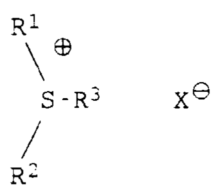

(I)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Maßgabe, daß mindestens einer der Reste $R^1$ bis $R^3$ mindestens eine durch Säure spaltbare Gruppierung enthält, wobei einer der Reste $R^1$ bis $R^3$ mit einem oder mehreren weiteren Sulfoniumsalzresten, gegebenenfalls über durch Säure abspaltbare Gruppierungen, verknüpft sein kann, und $X^{\ominus}$ ein nichtnukleophiles Gegenion bedeutet.

Als organische Verbindungen (c) kommen also solche der oben genannten organischen Verbindungen in Frage, die mit Wasser oder stärkeren Nucleophilen reagieren, beispielsweise unter Hydrolyse, Ammonolyse, Aminolyse oder Addition von Wasser bzw. Nucleophilen. Bevorzugt sind jedoch solche Verbindungen, welche schneller mit in der Schicht vorhandenen bzw. während eventuell auftretender Lagerzeiten eindringenden Nucleophilen bzw. Wasser reagieren als der photochemisch erzeugte Säurekatalysator und die Rückreaktion unter Freisetzung dieser Nucleophile bzw. Wasser unter den Verarbeitungsbedingungen nicht bzw. nur in untergeordnetem Maße stattfindet.

Gegenstand der vorliegenden Erfindung ist außerdem ein Verfahren zur Herstellung von Reliefmustern und Reliefbildern, wobei ein erfindungsgemäßes strahlungsempfindlichen Gemisch eingesetzt wird, das vorzugsweise nach der Belichtung auf Temperaturen zwischen 60°C und 120°C erhitzt wird.

Die erfindungsgemäßen strahlungsempfindlichen Gemische ermöglichen die Herstellung von Reliefmustern und Reliefbildern mit hoher Auflösung bei praxisgerechter Verarbeitbarkeit mit genügend großem Verarbeitungsspielraum, insbesondere mit tolerierbaren Lagerzeiten (> 10 Minuten) zwischen Belichtung und Ausheizschritt.

Weiterhin ist die Empfindlichkeit der Systeme durch die katalytische Wirkung der photochemisch erzeugten Säuren sehr hoch und es ergeben sich sehr hohe Kontrastwerte. Diese strahlungsempfindlichen Gemische sind daher für die Anwendung in der Deep-UV Lithographie sehr gut geeignet.

Zu den Aufbaukomponenten des erfindungsgemäßen strahlungsempfindlichen Gemisches ist im einzelnen folgendes auszuführen.

(a) Das polymere Bindemittel (a) besteht im wesentlichen aus Polymeren auf Basis von Homo- oder Copolymeren

des p-Hydroxistyrols und/oder p-Hydroxi-α-methylstyrols. Als Comonomereinheiten kommen dabei besonders in o-Stellung mono- oder disubstituierte Hydroxistyrole oder Hydroxistyrole, deren phenolische Gruppe mit säurelabilen Gruppierungen geschützt ist, in Frage, wobei als Substituenten in o-Stellung zur phenolischen OH-Gruppe Halogene und insbesondere Alkylgruppen mit 1 bis 4 Kohlenstoffatomen in Frage kommen. Besonders bevorzugte säurelabile Gruppierungen sind dabei t-Butylcarbonate, t-Amylcarbonate und t-Butylester. Die Polymeren weisen im allgemeinen mittlere Molekulargewichte $\overline{M}_w$ zwischen 2.000 und 100.000, vorzugsweise zwischen 10.000 und 30.000 auf.

Das polymere Bindemittel (a) ist im erfindungsgemäßen Gemisch im allgemeinen in einer Menge von 55 bis 98, vorzugsweise 70 bis 96 Gew.-%, bezogen auf die Summe der Komponenten (a) bis (c) enthalten.

(b) Besonders bevorzugte organische Verbindungen (b) sind solche der allgemeinen Formel (I),

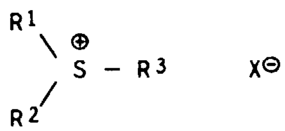

(I)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Maßgabe, daß mindestens einer der Reste $R^1$ bis $R^3$ mindestens eine durch Säure spaltbare Gruppierung, vorzugsweise t-Butylcarbonate von Phenolen bzw. Silylether von Phenolen enthält, wobei einer der Reste $R^1$ bis $R^3$ mit einem oder mehreren weiteren Sulfoniumsalzresten, gegebenenfalls über durch Säure spaltbare Gruppierungen, verknüpft sein kann und $X^{\ominus}$ ein nichtnucleophiles Gegenion bedeutet.

Als Gegenionen kommen bevorzugt komplexe Metallhalogenide, wie Tetrafluoroborat, Hexafluoroantimonat, Hexafluoroarsenat, und starke organische Säureanionen wie Trifluormethansulfonat und Fluorsulfonat, in Frage.

Es können auch zwei oder mehrere Sulfoniumeinheiten im Molekül über die Reste $R^1$ bis $R^3$ verknüpft sein. Die organischen Verbindungen (b) werden im allgemeinen in Mengen von 1 bis 15, bevorzugt 3 bis 10 Gew.-%, bezogen auf die Gesamtmenge des strahlungsempfindlichen Gemisches, eingesetzt.

Bevorzugte Sulfoniumsalze der allgemeinen Formel (I)

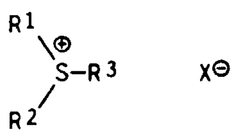

(I)

sind solche, in denen $R^1$ und $R^2$ für Methylgruppen und $R^3$ für substituierte Phenylderivate mit säurespaltbaren Gruppen stehen.

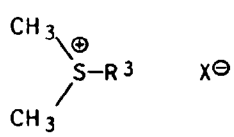

worin $R^3$ z.B. für 4-t-Butoxicarbonyloxi-phenyl-, 4-t-Butoxicarbonyloxloxi-3,5-dimethyl-phenyl-, 4-t-Butoxicarbonyloxi-3-methyl-phenyl-, 4-t-Butoxicarbonyloxi-2-methyl-phenyl-, 4-t-Butoxicarbonyloxi-3,5-dimethoxi-phenyl-, 4-t-Butoxicarbonyloxi-3,5-diphenyl-phenyl-, 1-t-Butoxicarbonyloxi-naphthyl-, 4-Trimethylsilyl-oxi-phenyl-, 4-Trimethylsilyl-oxi-naphthyl- stehen oder auch solche, in denen zwei der Reste $R^1$ bis $R^3$ miteinander zu einem Ring, insbesondere einem fünf-oder sechsgliedrigen Ring verknüpft sind, wobei z.B. $R^1$ und $R^2$ beispielsweise zu Tetramethylengruppen verbrückt sind und $R^3$ die gleiche Bedeutung wie vorstehend hat:

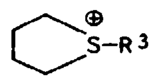

oder Verbindungen, in denen $R^1$ für Methyl und $R^2$ für Phenyl bzw. Tolyl stehen und $R^3$ für ein substituiertes Phenylderivat mit säurespaltbaren Gruppen steht, wie

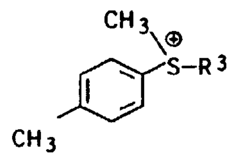

worin $R^3$, für 4-t-Butoxicarbonyloxi-phenyl, 2,4-Di-t-butoxicarbonyloxiphenyl-, 4-t-Butoxicarbonyloxi-2-methoxiphenyl-, 4-Trimethylsilylphenyl- steht,
oder worin $R^1$ für Phenyl oder $C_1$- bis $C_{12}$-alkyl-substituiertes Phenyl oder halogensubstituiertes Phenyl steht und $R^2$ und $R^3$ substituierte Phenylderivate mit säurespaltbaren Gruppen sind, wie z.B.

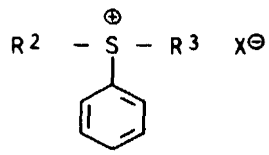

worin $R^2$ und $R^3$ z.B. 4-t-Butoxicarbonyloxi-phenyl, 4-Trimethylsilyloxiphenyl-, 4-t-Butyl-dimethyl-silyloxi-phenyl-, 4-t-Butoxicarbonyloxi-3,5-dimethyl-phenyl- oder $R^1$, $R^2$ und $R^3$ untereinander gleich sind, d.h. Sulfoniumsalze (b), in denen diese Reste mit säurespaltbaren Gruppen dreimal enthalten sind.

Weiterhin kommen auch Verbindungen der allgemeinen Formel (I) in Betracht, worin einer der Reste $R^1$ bis $R^3$ mit einem oder mehreren weiteren Sulfoniumsalzresten, gegebenenfalls über durch Säure spaltbare Gruppierungen verknüpft ist, die also ebenfalls mehrere Sulfoniumgruppen im Molekül aufweisen, wie z.B.

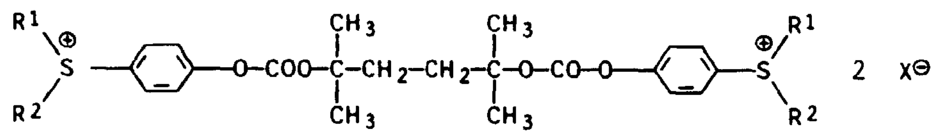

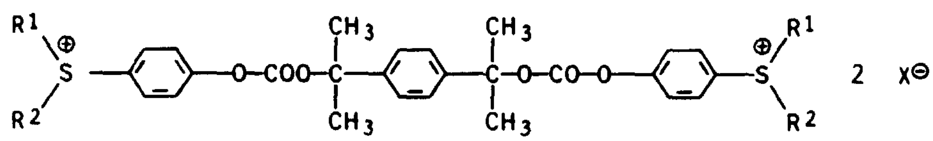

Die organischen Verbindungen (b) können nach den bekannten Methoden der organischen Chemie zur Synthese von Estern, Ethern und Carbonaten hergestellt werden, indem man von den Sulfoniumsalzen mit phenolischen Gruppen ausgeht und diese entsprechend derivatisiert. Ausgehend von Sulfoniumsalzen mit phenolischen Gruppen können diese mit Kalium-t-butylat umgesetzt werden, anschließend kann mit Di-t-butyl-dicarbonat die säurespaltbare Gruppe eingeführt oder alternativ das phenolische Sulfoniumsalz mit einer aktivierten Carbonylverbindung, z.B. dem t-Butyloxi-carbonyl-N-imidazol, umgesetzt werden. Für diese Umsetzung eignen sich insbesondere Hydroxiphenyl-sulfoniumsalze, die bereits ein nichtnucleophiles Anion, wie z.B. Hexafluoroantimonat enthalten. Solche Verbindungen können beispielsweise nach einer Synthesevorschrift in J. Polym. Sci., Chem. Ed., 18, 1021 (1980), hergestellt werden. Man kann beispielsweise die so hergestellten Verbindungen im trockenem Tetrahydrofuran lösen, Kalium-t-butylat in trockenem Tetrahydrofuran zugeben und anschließend eine Lösung

von Di-t-butyl-dicarbonat in Tetrahydrofuran zutropfen. Nach der Aufarbeitung und Umkristallisation enthält man dann die reinen Sulfoniumsalze mit säurelabilen Gruppen.

Bevorzugte Beispiele für organische Verbindungen (b) sind Dimethyl-4-t-butoxicarbonyloxiphenyl-sulfoniumsalz mit Hexafluoroarsenat, Hexafluoroantimonat, Hexafluorophosphat, Hexafluoroborat oder Trifluormethansulfonat als Gegenion, Phenyl-bis-(4-t-butoxicarbonyloxiphenyl-)sulfoniumsalz mit den genannten Gegenionen, Tris-(4-t-butoxicarbonyloxiphenyl-) sulfoniumsalz mit den genannten Gegenionen oder 1-Naphthyl-4-trimethylsilyloxitetramethylen-sulfoniumsalz mit den genannten Gegenionen.

(c) Als organische Verbindungen (c), die bei Temperaturen von bis zu 120°C, gegebenenfalls auch säurekatalysiert, mit Wasser oder stärkeren Nucleophilen, reagieren, kommen bevorzugt Acetale und Ketale, wie Dialkylacetale und Dialkylketale, worin jeweils die Alkylreste 1 bis 12, vorzugsweise 1 bis 4 Kohlenstoffatome enthalten können, wie beispielsweise Dialkylacetale des Propionaldehyds, Butyraldehyds, Benzaldehyds, Dialkylketale von Hexanon-(2), Acetophenon oder Cyclohexanon, Vinyl- und Enolether, wie Isobutyl-vinylether, Dihydropyran, 4-Phenyl-2H-3,4-dihydropyran, Enolether wie

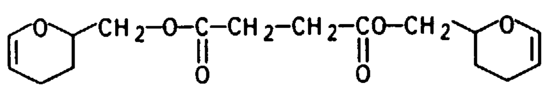

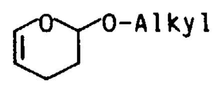

Alkyl = $C_1$-$C_{12}$

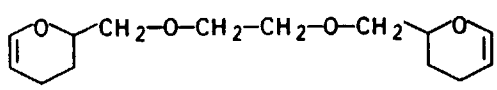

und andere Vinyl- und Enolether wie sie in DE-A-23 06 248 beschrieben sind,
Orthocarbonsäureester der Formel

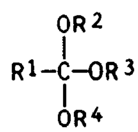

wobei $R^1$ = H, eine substituierte oder unsubstituierte Alkylgruppe mit 1 bis 12 Kohlenstoffatomen, eine substituierte oder unsubstituierte Phenylgruppe, oder eine substituierte oder unsubstituierte Cycloalkylgruppe mit 5 oder 6 Kohlenstoffatomen ist, $R^2$ bis $R^4$ gleich oder verschieden sind und für Alkyl oder Alkenyl mit 1 bis 12 Kohlenstoffatomen, Cycloalkyl, Cycloalkenyl mit jeweils 5 oder 6 C-Atomen oder substituiertes oder unsubstituiertes Aryl, insbesondere Phenyl, stehen. Solche Verbindungen und beispielsweise in US-A 4 101 323 beschrieben;
Carbonsäureanhydride von aliphatischen Carbonsäuren, wie z.B. Essigsäureanhydrid, Propionsäureanhydrid, Buttersäureanhydrid, Hexansäureanhydrid, fluorierte Carbonsäureanhydride, wie Perfluorbuttersäureanhydrid, Malonsäureanhydrid, Bernsteinsäureanhydrid, Glutarsäureanhydrid oder Adipinsäureanhydrid ;
Carbonsäureester von Di- oder Polycarbonsäuren mit 1 bis 4 Kohlenstoffatome enthaltende Alkoholen, wie Oxalsäure-dimethylester, Oxalsäure-diethylester, Malonsäure-dimethylester, cyclische Carbonsäureester, wie Meldrumsäure, Methyl-meldrum-Säure, sowie
Diazo- oder Diazonium-verbindungen, welche mit Licht unter Stickstoffabspaltung reagieren und reaktive Zwischenstufen freisetzen, die mit Wasser oder anderen Nucleophilen reagieren können, wie die kommerziell erhältlichen o-Naphthochinondiazide, Diazomeldrumsäure und lösliche Diazoniumsalze.

Prinzipiell kommen alle diese Verbindungen sowie deren Gemische als organische Verbindungen (c) in Frage, besonders bevorzugt sind jedoch solche Verbindungen mit Siedepunkten > 140°C und guter Löslichkeit in mittelpolaren Lösungsmitteln, wie Methoxypropylacetat, Cyclohexanon, Ethyllactat und Diacetonalkohol.

Die organischen Verbindungen (c) sind im erfinderischen strahlungsempfindlichen Gemisch in einer Menge von 0,1 bis 10, vorzugsweise 0,5 bis 5 Gew.-%, bezogen auf die Gesamtmenge der Komponenten (a) + (b) + (c) enthalten.

Bei dem erfindungsgemäßen Verfahren zur Herstellung von Reliefmustern und Reliefbildern wird eine strahlungsempfindliche Aufzeichnungsschicht, die im wesentlichen aus dem erfindungsgemäßen strahlungsempfindlichen Gemisch besteht, das zweckmäßigerweise in einem inerten Lösungsmittel, wie z.B. Methyl-propylenglykolacetat, Methylcellosolveacetat oder Ethylcellosolveacetat gelöst, in üblicher Weise, beispielsweise durch Aufschleudern (spin coating) auf ein geeignetes Substrat, wie z.B. einen Siliciumwafer in Schichtdicken (trocken gemessen) von 0,2 bis 4 µm aufgetragen und getrocknet wurde, bildmäßig in solcher Dosis bestrahlt und bei Temperaturen von 60 bis 120°C während 5 Sekunden bis 5 Minuten ausgeheizt, so daß die Löslichkeit der belichteten Bereiche in wäßrig-alkalischen Lösungsmitteln, beispielsweise alkalischen Entwicklern von pH 10-14, enthaltend Alkalihydroxide, Alkalisilikate oder Amine, wie Tetramethylammoniumhydroxid, zunimmt und diese bestrahlten Bereiche selektiv mit dem alkalischen Entwickler entfernt werden können.

Die Gemische weisen hohe Empfindlichkeit und Kontraste auf. Es entstehen Reliefstrukturen guter Strukturqualität.

Weitere Angaben über Zusammensetzung und Weiterverarbeitung strahlungsempfindlicher Gemische können beispielsweise auch der DE-A 37 21 741 entnommen werden.

Die in den Beispielen genannten Teile und Prozente sind, soweit nicht anders angegeben, Gewichtsteile und Gewichtsprozente.

Beispiel 1:

Eine Photoresistlösung wird aus 15 Teilen Tris-(4-t-butoxicarbonyloxiphenyl-)sulfoniumtrifluormethansulfonat, 5 Teilen Glutarsäure-anhydrid, 80 Teilen Poly-(p-vinylphenol) und 300 Teilen Methyl-propylenglykol-acetat hergestellt. Die Lösung wird anschließend durch ein Filter mit einem Porendurchmesser von 0,2 µm filtriert.

Diese Resistlösung wird auf einen Siliciumwafer mit einem $SiO_2$-Film in einer Schichtdicke von ca. 1,0 µm aufgeschleudert. Der Wafer wird eine Minute bei 90°C getrocknet, anschließend mit einer bildmäßig strukturierten Testmaske in Kontakt gebracht und 3 Sekunden mit Excimer-Laserlicht der Wellenlänge 248 nm belichtet.

Dann läßt man den Wafer 1 Stunde liegen (21°C, relative Raumfeuchte 45 %), um eventuell auftretende Wartezeiten zwischen den einzelnen Prozeßschritten zu simulieren.

Anschließend wird der Wafer 1 Minute bei 90°C ausgeheizt und mit einem alkalischen Entwickler entwickelt. Der Wafer läßt sich einwandfrei zu einem positiven Reliefmuster entwickeln und zeigt die gleiche Charakteristik wie ein Vergleichswafer der direkt nach der Belichtung ausgeheizt wurde.

Vergleichsbeispiel

Es wird wie in Beispiel 1 verfahren, jedoch enthält die Resistlösung kein Glutarsäureanhydrid, stattdessen 85 % Polymer. Nach einer Stunde Lagerzeit zwischen Belichtung und Ausheizen ist das Resistmuster mit dem gleichen Entwickler nicht mehr entwickelbar.

Beispiel 2

Eine Photoresistlösung wird aus 10 Teilen Tris-(4-t-butoxicarbonyloxiphenyl-)sulfoniumtrifluoromethansulfonat, 80 Teilen Poly-(p-vinylphenolco-p-t-butoxicarbonyloxi-styrol), 10 Teilen Adipinsäureanhydrid und 300 Teilen Cyclohexanon hergestellt. Die Lösung wird anschließend durch ein Filter mit einem Porendurchmesser von 0,2 µm filtriert.

Diese Resistlösung wird auf einem Siliciumwafer in einer Schichtdicke von ca. 1 µm aufgebracht und 1 Minute bei 100°C auf einer Heizplatte ausgeheizt. Dann belichtet man bildmäpig durch eine strukturierte Testmaske im Kontaktverfahren während 4 Sekunden mit Excimer-Laserlicht der Wellenlänge 248 nm.

Man läßt den Wafer 30 Minuten liegen, heizt anschließend bei 100°C 1 Minute aus und entwickelt. Das Resistmuster läßt sich ohne Lackrückstände entwickeln und es entstehen Resistmuster guter Qualität mit steilen Flanken.

Beispiel 3

Es wird wie in Beispiel 1 verfahren, jedoch wird anstatt des Glutarsäureanhydrids Oxalsäure-diethylester eingesetzt. Die Resistmuster sind nach 25-minütigem Liegenlassen noch einwandfrei zu entwickeln, während ein Vergleichswafer ohne den Oxalsäureester bereits nach 10 Minuten nicht mehr rückstandsfrei entwickelbar ist.

Beispiele 4 bis 6

Es wird wie in Beispiel 1 verfahren, jedoch wird wie folgt belichtet bzw. gelagert:

| Verbindung (c) | Belichtungszeit [sec] | Lagerzeit [min] |
|---|---|---|
| (4) 5 % Triethyl-o-ameisensäureester | 3 | 20 |
| (5) 5 % 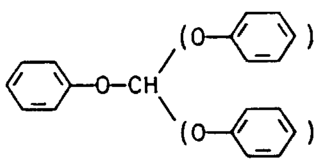 | 4 | 25 |
| (6) 5 % 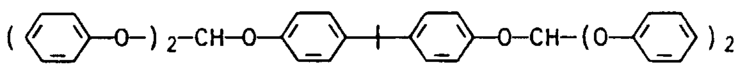 | 3 | 25 |

Bis zu den angegebenen Lagerzeiten sind alle Resistmuster nach einem Ausheizschritt 1 Minute/90°C noch rückstandsfrei entwickelbar.

Beispiel 7

Es wird wie in Beispiel 2 verfahren, jedoch wird anstatt Adipinsäureanhydrid folgender Enolether eingesetzt:

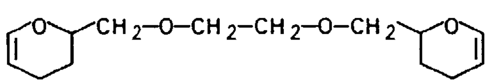

Nach einer Belichtungszeit vond 5 Sekunden kann man die Wafer bis zu 30 Minuten liegenlassen ohne daß sich das Entwicklungsverhalten von sofort nach der Belichtung ausgeheizten Wafern unterscheidet.

Beispiel 8

Es wird eine Photoresistlösung aus 10 Teilen Dimethyl-4-t-butoxicarbonyloxiphenylsulfoniumhexafluoroarsenat, 86 Teilen Poly-(vinylphenol-co-p-t-amyloxicarbonyloxi-styrol), 4 Teilen Diazo-Meldrumsäure und 300 Teilen Ethyllactat hergestellt und durch ein Filter mit einer Porenweite von 0,2 µm filtriert.

Die Resistlösung wird in einer Schichtdicke von ca. 1 µm auf einen Wafer aufgebracht und bildmäßig belichtet. Man kann anschließend bis zu 15 Minuten lagern, ohne daß sich das Entwicklungsverfahren ändert, während ein Vergleichswafer ohne die Diazo-meldrumsäure nach zehnminütiger Lagerzeit schon Rückstände auf dem Wafer erkennen ließ.

**Patentansprüche**

**1.** Strahlungsempfindliches Gemisch, enthaltend

(a) ein in Wasser unlösliches, in wäßrig-alkalischen Lösungen lösliches polymeres Bindemittel auf Basis von Homo- oder Copolymeren des p-Hydroxistyrols und/oder p-Hydroxi-α-methylstyrols und

(b) eine organische Verbindung, deren Löslichkeit in einem wäßrig-alkalischen Entwickler durch Einwirkung von Säure erhöht wird und die mindestens eine durch Säure spaltbare Gruppierung sowie zusätzlich eine Gruppierung, die unter Einwirkung von Strahlung eine starke Säure bildet, enthält,

dadurch gekennzeichnet, daß das strahlungsempfindliche Gemisch zusätzlich (c) mindestens eine organische Verbindung enthält, die bei Temperaturen von bis zu 120°C, gegebenenfalls auch säurekatalysiert, mit Wasser

oder stärkeren Nukleophilen reagiert, wobei diese organischen Verbindungen (c) ausgewählt sind aus der Gruppe der Vinyl- oder Enolether, der Orthocarbonsäureester der Formel

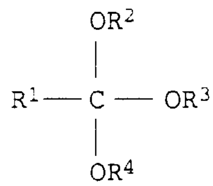

wobei $R^1$ = H, eine substituierte oder unsubstituierte Alkylgruppe mit 1 bis 12 Kohlenstoffatomen, eine substituierte oder unsubstituierte Phenylgruppe, oder eine substituierte oder unsubstituierte Cycloalkylgruppe mit 5 oder 6 Kohlenstoffatomen ist, $R^2$ bis $R^4$ gleich oder verschieden sind und für Alkyl oder Alkenyl mit 1 bis 12 Kohlenstoffatomen, Cycloalkyl, Cycloalkenyl mit jeweils 5 oder 6 C-Atomen oder substituiertes oder unsubstituiertes Aryl stehen, der Carbonsäureanhydride aliphatischer Carbonsäuren, der Carbonsäureester von Di- oder Polycarbonsäuren mit 1 bis 4 Kohlenstoffatome enthaltenden Alkoholen, der Diazo- oder Diazoniumverbindungen und der Acetale und Ketale, wobei Monoketale von β-Dicarbonylverbindungen ausgenommen sind.

**2.** Strahlungsempfindliches Gemisch nach Anspruch 1, dadurch gekennzeichnet, daß die organische Verbindung (b) ein Sulfoniumsalz der allgemeinen Formel (I) ist

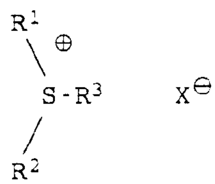 (I)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Maßgabe, daß mindestens einer der Reste $R^1$ bis $R^3$ mindestens eine durch Säure spaltbare Gruppierung enthält, wobei einer der Reste $R^1$ bis $R^3$ mit einem oder mehreren weiteren Sulfoniumsalzresten, gegebenenfalls über durch Säure abspaltbare Gruppierungen, verknüpft sein kann, und $X^\ominus$ ein nichtnukleophiles Gegenion bedeutet.

**3.** Strahlungsempfindliches Gemisch nach Anspruch 1 oder 2, dadurch gekennzeichnet, daß als organische Verbindung (c) ein Gemisch aus mindestens zwei der in Anspruch 1 genannten organischen Verbindungen (c) eingesetzt wird.

**4.** Strahlungsempfindliches Gemisch nach einem der vorhergehenden Ansprüche, dadurch gekennzeichnet, daß die organische Verbindung (c) in einer Menge von 0,1 bis 10 Gew.-%, bezogen auf die Gesamtmenge des strahlungsempfindlichen Gemisches (a) + (b) + (c), enthalten ist.

**5.** Verfahren zur Herstellung von Reliefmustern und Reliefbildern, dadurch gekennzeichnet, daß man als lichtempfindliche Beschichtungsmaterialien ein strahlungsempfindliches Gemisch gemäß einem der vorhergehenden Ansprüche einsetzt.

**6.** Verfahren zur Herstellung von Reliefmustern nach Anspruch 5, dadurch gekennzeichnet, daß nach der Belichtung des strahlungsempfindlichen Gemisches auf Temperaturen zwischen 160 und 120°C erhitzt wird.

## Claims

**1.** A radiation-sensitive mixture comprising

(a) a water-insoluble but alkali-soluble polymeric binder based on homopolymers or copolymers of p-hydroxystyrene and/or p-hydroxy-α-methylstyrene, and
(b) an organic compound whose solubility in aqueous alkali is increased by the action of an acid and which contains at least one acid-cleavable group and additionally a group which forms a strong acid on irradiation,

characterized in that the radiation-sensitive mixture further comprises (c) at least one organic compound which reacts with water or stronger nucleophiles at up to 120°C, if necessary even in the presence of an acid catalyst, these organic compounds (c) being selected from the group consisting of the vinyl or enol ethers, the orthocarboxylic esters of the formula

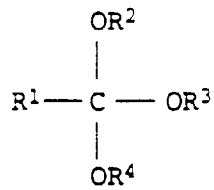

where $R^1$ is hydrogen, substituted or unsubstituted alkyl of from 1 to 12 carbon atoms, substituted or unsubstituted phenyl or substituted or unsubstituted cycloalkyl of 5 or 6 carbon atoms, and $R^2$ to $R^4$ are identical or different and each is alkyl or alkenyl of from 1 to 12 carbon atoms, cycloalkyl or cycloalkenyl each of 5 or 6 carbon atoms or substituted or unsubstituted aryl, the anhydrides of aliphatic carboxylic acids, the esters of di- or polycarboxylic acids with alcohols containing from 1 to 4 carbon atoms, the diazo or diazonium compounds and the acetals and ketals, subject to the proviso that monoketals of β-dicarbonyl compounds shall be excluded.

2. A radiation-sensitive mixture as claimed in claim 1, characterized in that the organic compound (b) is a sulfonium salt of the formula (I)

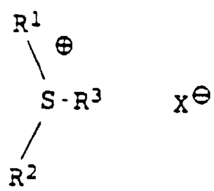

(I)

where $R^1$, $R^2$ and $R^3$ are identical or different and each is an aliphatic or aromatic radical which may contain hetero atoms or two of $R^1$ to $R^3$ form a ring, with the proviso that at least one of $R^1$ to $R^3$ contains at least one acid-cleavable group, while one of $R^1$ to $R^3$ can be linked to one or more further sulfonium salt radicals, where appropriate via an acid-cleavable group, and $X^{\ominus}$ is a non-nucleophilic counter-ion.

3. A radiation-sensitive mixture as claimed in claim 1 or 2, characterized in that the organic compound (c) is a mixture of at least two of the organic compounds (c) mentioned in claim 1.

4. A radiation-sensitive mixture as claimed in any of the preceding claims, characterized in that the organic compound (c) is present in an amount of from 0.1 to 10 % by weight, based on the total amount of the radiation-sensitive mixture (a) + (b) + (c).

5. A process for producing relief patterns and images, characterized in that it comprises using a radiation-sensitive mixture as claimed in any one of the preceding claims as light-sensitive coating material.

6. A process as claimed in claim 5, characterized in that irradiation of the radiation-sensitive mixture is followed by heating to 60-120°C.

## Revendications

1. Mélange sensible aux rayonnements, contenant

(a) un liant polymère insoluble dans l'eau mais soluble dans les solutions aqueuses alcalines, à base d'homo- ou co-polymères du p-hydroxystyrène et/ou du p-hydroxy-alpha-méthylstyrène et

(b) un composé organique dont la solubilité dans un révélateur aqueux alcalin est accrue sous l'action d'un acide et qui contient au moins un groupement scindable par les acides et en outre un groupement qui, sous l'action des radiations, forme un acide fort,

caractérisé par le fait que le mélange sensible aux rayonnements contient en outre au moins un composé organique qui, à des températures allant jusqu'à 120°C, éventuellement avec catalyse par des acides, réagit avec l'eau ou les nucléophiles puissants, ce composé organique (c) étant choisi dans le groupe des éthers vinyliques ou des éthers d'énols, des esters d'acides orthocarboxyliques de formule

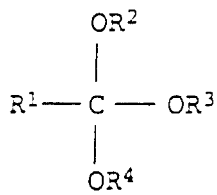

dans laquelle $R^1$ représente H, un groupe alkyle en C1-C12 éventuellement substitué, un groupe phényle éventuellement substitué ou un groupe cycloalkyle en C5-C6 éventuellement substitué, $R^2$ à $R^4$, ayant des significations identiques ou différentes, représentent chacun un groupe alkyle ou alcényle en C1-C12, cycloalkyle ou cycloalcényle en C5-C6 ou aryle éventuellement substitué, des anhydrides d'acides carboxyliques aliphatiques, des esters d'acides di- ou poly-carboxyliques et d'alcools en C1-C4, des diazoïques ou des dérivés de diazonium et des acétals et cétals, à l'exception des monocétals des dérivés bêta-dicarbonylés.

2. Mélange sensible aux rayonnements selon la revendication 1, caractérisé par le fait que le composés organique (b) est un sel de sulfonium de formule générale I

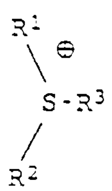 $X^{\ominus}$ (I)

dans laquelle $R^1$, $R^2$ et $R^3$, identiques ou différents, représentent chacun un radical aliphatique et/ou aromatique qui peut le cas échéant contenir des hétéroatomes, ou bien deux des groupes $R^1$ à $R^3$ sont reliés entre eux avec formation d'un cycle, sous réserve qu'au moins un des groupes $R^1$ à $R^3$ contient au moins un groupement scindable sous l'action des acides, l'un des groupes $R^1$ à $R^3$ pouvant être relié à un ou plusieurs autres radicaux de sels de sulfonium, le cas échéant par l'intermédiaire de groupements scindables sous l'action des acides, et $X^{\ominus}$ représente un ion complémentaire non nucléophile.

3. Mélange sensible aux rayonnements selon la revendication 1 ou 2, caractérisé par le fait que le composé organique (c) consiste en fait en un mélange d'au moins deux des composés organiques (c) énumérés dans la revendication 1.

4. Mélange sensible aux rayonnements selon une des revendications qui précèdent, caractérisé par le fait que le composé organique (c) est contenu en quantité de 0,1 à 10 % en poids, par rapport à la quantité totale du mélange sensible aux rayonnements : (a) + (b) + (c).

5. Procédé pour former des modèles en relief et des images en relief, caractérisé par le fait que l'on utilis, en tant que matériau de revêtement photosensible, un mélange sensible aux rayonnements selon l'une des revendications qui précèdent.

6. Procédé pour former des modèles en relief selon la revendication 5, caractérisé par le fait que, après exposition du mélange sensible aux rayonnements, on le chauffe à des températures de 60 à 120°C.